# EUROPEAN PATENT APPLICATION

(11) **EP 1 282 206 A1**
(43) Date of publication of application: **05.02.2003**
(21) Application number: 01306506.5
(22) Date of filing: 30.07.2001
(51) Int. Cl.: H01S 5/022, H01S 5/024, H01L 23/40

(54) **Method and apparatus for cooling electronic or optoelectronic devices**

(71) Applicant: Agilent Technologies, Inc. (a Delaware corporation), Palo Alto, CA 94303 (US)
(72) Inventor: Harding, Ryan Kingsley, Bexhill-On-Sea, East Sussex TN39 3NL (GB)
(74) Representative: Coker, David Graeme

(57) **Abstract**

An electronic device such as a laser diode (102) is mounted on a heatsink assembly (126, 128) within a TO-can package. The TO-can package is coupled to a thermal sink (146), such as a printed circuit board or housing, by a thermal conductor. The thermal conductor is in the form of a thermal clip (140), a flexible strap (404) or alternatively a heat pipe (306). Thus, heat energy is efficiently conducted away from devices within the TO-can package (402).

## Description

### Field of the Invention

This invention relates, in general, to a method and apparatus for cooling electronic or opto-electronic devices.

### Background of the Invention

Electronic and opto-electronic devices usually consume power which leads to an increase in temperature which affects the ability of the device to function in an optimum manner and shortens the life of the device. Active electronic devices are particularly susceptible to retaining substantial heat energy, but passive electronic devices can also be victim to this where the device absorbs heat energy from nearby radiant devices.

In the field of optical electronic devices, it is known to utilise various types of cooling (or drawing heat energy away from the device). For example, laser diodes are often housed within so-called "Transistor Outline (TO)-Cans", which are metallic, generally cylindrically-shaped housings. The laser diode is mounted on a heatsink attached to the "lid" of the housing, providing only a small temperature reduction. The "lid", which is usually known as a "header", is thermally coupled to the heatsink. The heatsink dissipates thermal energy into the header of the housing which, in turn, radiates the thermal energy away. However, radiation of thermal energy is not very efficient, especially when the TO-can is enclosed within a module together with a printed circuit board (PCB) which may have other heat-radiating devices mounted thereon.

Another example of thermal management is forced airflow, which necessitates the additional device of a fan. The fan uses power and space, and can potentially create Electro-Magnetic Compatibility (EMC) problems due to the provision of vents in an Electro-Magnetic Interference (EMI) shield.

Furthermore, the use of a fan adds extra expense and reliability concerns, and is limited in its uses, since it cannot easily be used under conditions of vacuum or water.

Further examples of thermal management are a Peltier cooler or fluid cooling which generally require an extra power supply, thus consuming more power and contributing to overall heat energy within the device. Extra space is required to accommodate them within the device. Also, significant additional cost and potentially unreliability is incurred through introduction of such device into the device.

Therefore, it is an object of the present invention to provide a method of cooling an electronic or opto-electronic device which overcomes, or at least reduces the disadvantages of the known devices described above.

### Brief Summary of the Invention

Accordingly, in a first aspect, the present invention provides a method for cooling an electronic or opto-electronic device, the method comprising the steps of: providing an electronic or opto-electronic device; mounting said device on a heat sink assembly; sealing said heat sink assembly within a can having a can body and a can header thermally coupled to the heat sink assembly and closing the can body; and attaching a first portion of a thermal conductor outside said can to at least part of an edge of the header and a second portion of the thermal conductor to a thermal sink outside said can.

Preferably, said device is a laser device.

The thermal conductor may be a clip of thermally conducting material, wherein said first portion includes an annular part for fitting around the edge of the header of the can and said second portion includes a substantially planar part for attaching to the thermal sink.

Alternatively, said thermal conductor can be a heat pipe.

In an alternative embodiment, said thermal conductor can be a flexible strap of thermally conducting material which is arranged around at least part of the edge of the header and attached to the thermal sink.

Preferably, said can is a Transistor Outline (TO) can.

According to a second aspect of the present invention, there is provided an electronic or opto-electronic device assembly comprising an electronic or opto-electronic device mounted on a heatsink assembly within a can having a can body and a can header thermally coupled to the heat sink assembly and closing the can body, and a thermal conductor outside said can and having a first portion attached to at least part of an edge of the can header and a second portion attached to a thermal sink outside said can.

Preferably, said device is a laser device.

The thermal conductor may be a clip of thermally conducting material, wherein said first portion includes an annular part for fitting around the edge of the header of the can and said second portion includes a substantially planar part for attaching to the thermal sink.

Preferably, said first portion of said clip is substantially perpendicular to said second portion of said clip, and said clip may include at least one further portion for supporting said clip in position.

Alternatively, said thermal conductor can be a heat pipe.

In an alternative embodiment, said thermal conductor is a flexible strap of thermally conducting material which is arranged around the edge of the header and attached to the thermal sink.

The thermal sink is preferably part of a housing of the assembly.

Preferably, an electrically insulating, but thermally conductive material is arranged between the thermal conductor and the thermal sink.

In a preferred embodiment, the can is a Transistor Outline (TO) can.

### Brief Description of the Drawings

Several embodiments of the present invention will now be described, by way of example, with reference to the accompanying drawings, of which:
FIG.1 is an illustration of a first embodiment of the present invention in which a laser diode is connected to a thermal sink;
FIG.2 is an illustration of four different implementations of the first embodiment of the present invention;
FIG.3 shows a second embodiment of the present invention in which a laser diode is connected to a thermal sink; and
FIG.4 shows a third embodiment of the present invention in which a laser diode is connected to a thermal sink.

### Detailed Description of the Drawings

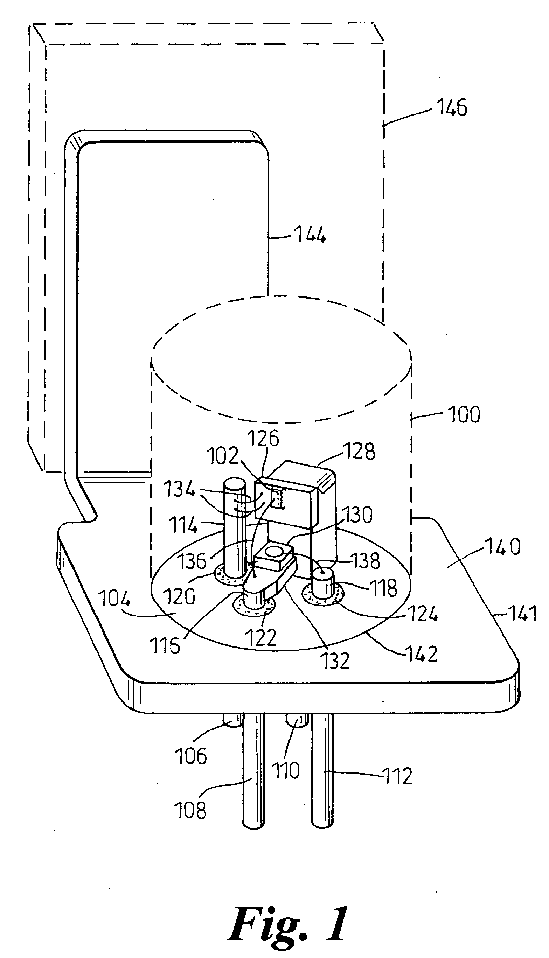

Thus, FIG.1 shows an electronic package having a laser diode 102 mounted in a TO-Can body 100, with further components (not shown) being housed in other parts of the body 100. The To-Can body 100 is generally cylindrical and incorporates a TO-Can header 104 having four pins 106, 108, 110, 112, of which pins 106, 108, 112 pass through the central part of the header 104 to an internal portion of the TO-Can body 100 for connection to the electrical components therewithin, whereas pin 110 is brazed to the header 104. Each of the three pins 106, 108, 112 is held in position by a glass seal 120, 122, 124 surrounding the respective pin where it passes through the TO-Can header 104. A cathode pin 106 terminates in the form of a cathode 114 on an internal side of the TO-Can header 104, an anode pin 108 terminates in the form of an anode 116 on the internal side of the TO-Can header 104, and a photodiode pin 112 terminates in the form of a photodiode terminal 118 on the internal side of the TO-Can header 104. A laser heatsink pin 110 is brazed to the header 104 adjacent to a laser heatsink assembly on the internal side of the TO-Can header 104.

Specifically the laser heatsink assembly comprises a laser heatsink block 128 and a laser heatsink 126 of Silicon Carbide (SiC) or Aluminium Nitride (AIN), which is thermally conductive and electrically insulating, is attached to a surface of the laser heatsink block 128 and a laser diode 102 is located on a surface of the laser heatsink 126. The anode 116 of anode pin 108 terminates in a metal tab 132, which extends below the metal laser heatsink 126 and has a photodiode 130 positioned thereon. A pair of bond wires 134 couple the laser heatsink 126 to the cathode 114, a bond wire 136 couples the laser diode 102 to the anode 116, and a further bond wire 138 couples the anode off the photodiode 130 to the photodiode terminal 118. The cathode of the photodiode 130 is electrically attached to the metal tab 132, such that the photodiode is reverse biased.

A thermal clip 140 is positioned around the TO-Can package. The thermal clip 140 is made of a thermally conductive material (often copper). A first portion 141 of the thermal clip 140 has an annular opening 142, which is slightly elongated, into which the TO-Can header 140 fits and is secured by solder or adhesive (which is a thermally conductive type of solder or adhesive). Approximately perpendicular to the first portion 141 of the thermal clip 140 is a second portion 144 which is substantially planar. The second portion 144 is positioned so that it is in contact with a thermal sink 146 which may be part of a housing of a larger assembly. In the present embodiment, the second portion 144 is fixed to the thermal sink 146 by an adhesive, but may equally be fixed by other means such as, for example, a nut and bolt. Optionally, an electrically insulating, but thermally conductive material (not illustrated) is positioned between the second portion 144 of the thermal clip 140 and the thermal sink 146. Furthermore, such a material may also have adhesive properties on both a front face and a back face, enabling the material to serve a dual purpose.

In operation, a high frequency input signal is applied to the cathode 114 and a supply voltage is applied to the anode 116. Light energy and heat energy are emitted from the laser diode 102 and the heat energy is mainly conducted into the laser heatsink 126 and then into the laser heatsink block 128 from where it is conducted to the TO-Can header 104. The heat energy is then conducted from the periphery of the TO-Can header 104 into the first portion 141 of the thermal clip 140 and subsequently into the second portion 144 of the thermal clip 140. The heat energy is then conducted into the thermal sink 146 (via the electrically insulating, thermally conductive material if it is present), where it is dissipated.

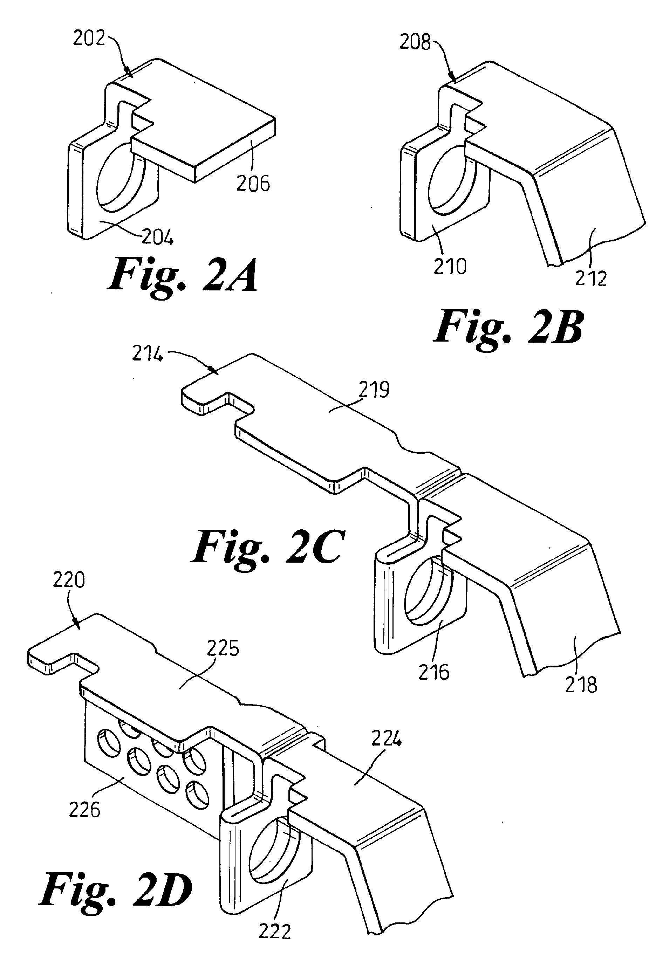

FIG.2A, FIG.2B, FIG.2C and FIG.2D show four different implementations 202, 208, 214, 220 of the thermal clip 140 of the first embodiment (as illustrated in FIG.1). Each implementation has a first portion 204, 210, 216, 222 having an annular opening approximately similar to the equivalent first portion 141 of the embodiment of FIG. 1. Furthermore, each implementation 202, 208, 214, 220 includes a second portion 206, 212, 218, 224 which performs the same function as the equivalent second portion 144 of FIG. 1. However, the exact configuration of the first portion 204, 210, 216, 222 and the second portion 206, 212, 218, 224 is dependent upon the type of package used, the architecture of the device in which the thermal clip is used and the method of manufacture of the thermal clip. Clearly, a larger surface area of the second portion 206, 212, 218, 224 leads to faster dissipation of heat energy and offers greater mechanical support. Specifically, in FIG.2A implementation 202 is made of machined copper 0.8mm in thickness. A top surface of the second portion 206 can be adhered to a surface in the device to stabilise the position of the package. In FIG.2B, implementation 208 (also manufactured from machined copper) includes an elongated second portion 212 which can have a cut-out in the extreme end, as illustrated. The elongated second portion 212 is bent to make an obtuse angle so that the cut-out can rest on a further part of the system, for example on an optical sub-assembly, thus mechanically stabilising the clip prior to soldering or another form of fixing. In FIGs.2C and 2D, implementations 214 and 220 are etched and manufactured from sheet metal cut and bent into the required shape. Implementations 214 and 220 have elongated, bent second portions 218 and 224, similar to the second portion 212 of the implementation 208 of FIG.2B. In addition, implementations 214 and 220 include an additional elongated portion 219, 225 extending in the opposite direction from the second portion 218, 224. Such additional portions 219, 225 increase mechanical support and heat energy dissipation. Furthermore, additional portion 225 includes a flat plate 226 with holes cut in it in order to limit the thermal conductance between nearby powered devices (such as integrated circuits) and the TO-can package.

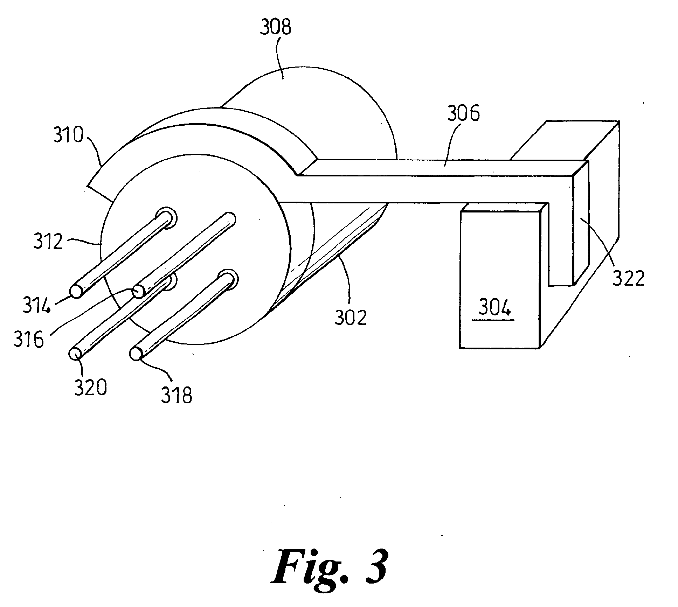

FIG. 3 illustrates a TO-can package 302 connected to a thermal sink 304 by a heat pipe 306, which heat pipe 306 works on a well-known principle to transfer a substantial amount of heat across a small temperature gradient. The TO-can package 302 is similar to the TO-can package FIG. 1 and has similar devices (not illustrated) inside a TO-can body 308. A first end 310 of the heat pipe 306 is in contact with an edge of a TO-can header 312. Electrical pins 314, 316, 318, 320 are also illustrated, three of which are insulated from the header by glass seals, and one being brazed to the header, as described above. A second end 322 of the heat pipe 306 is in contact with the thermal sink 304 which may be part of a housing of an electrical device.

In operation, the thermal energy generated by components within the TO-can package 302 is conducted into the first end 310 of the heat pipe 306. The heat pipe 306 comprises a sealed tube, generally of copper, which is evacuated and charged with a phase change liquid. The liquid at the first end 310 absorbs thermal energy and, as the liquid gets hotter, evaporation occurs. The vapour moves to the second end 322 of the heat pipe 306 where it condenses due to a transfer of thermal energy from the vapour to the thermal sink 304. The liquid returns to the first end 310 of the heat pipe 306 by capillary action utilising a "wick" action. However, it will be appreciated by the skilled artisan that the TO-can package 302 and the thermal sink 304 are generally in dynamic equilibrium and therefore the fluid in the first end 310 of the heat pipe 306 experiences net evaporation and the fluid in the second end 322 of the heat pipe 306 experiences net condensation. Due to the difference in vapour pressure, there is a net flow of vapour from the first end 310 to the second end 322 and a net flow of liquid from the second end 322 to the first end 310. The heat pipe is thus quite efficient at removing heat from the "hot" end, since the latent heat of vaporisation is used to draw thermal energy away.

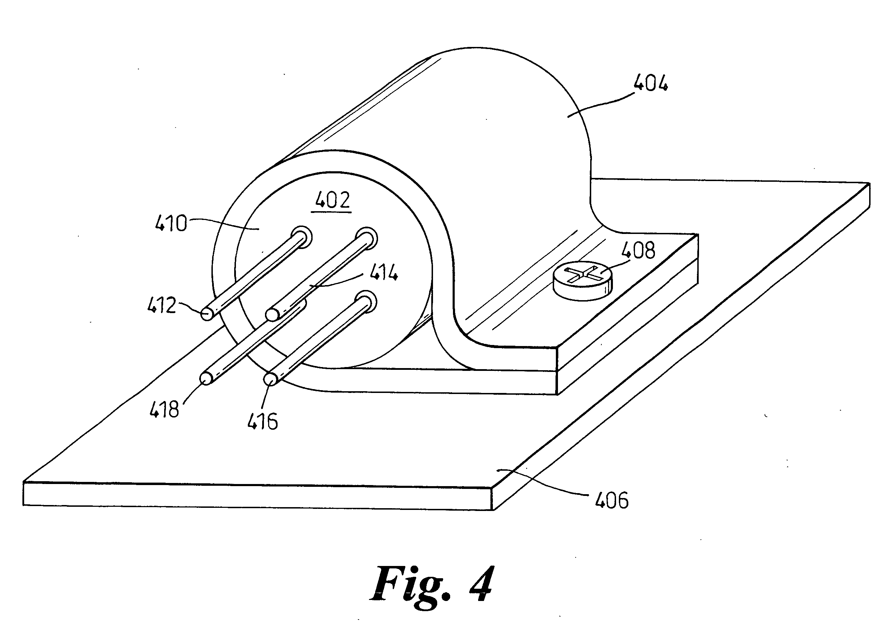

FIG. 4 illustrates a TO-can package 402 surrounded by a flexible strap 404 made from a thermally conducting material. Also shown is a TO-can header 410 and electrical pins 412, 414, 416, 418, three of which are insulated from the header by glass seals, and one being brazed to the header, as described above. The flexible strap 404 is in contact with at least part of an edge of the header 410. The flexible strap 404 is secured to a thermal sink (such as a PCB or a housing) 406 by a screw 408 (but alternatively the strap 404 can be soldered, brazed, glued or secured by other suitable means).

In operation, the strap 404 performs a similar function to the thermal clip 140, 144 of FIG. 1 by conducting thermal energy away from the TO-can package 402 into the thermal sink 406.

Advantage is obtained in each of the above described implementations by conducting thermal energy away from the TO-can package. High levels of thermal energy within the TO-can package may damage devices or stop the devices functioning in an optimum manner. Furthermore, advantage is obtained by the mechanical support provided to the TO-can by the various embodiments of the present invention. Such support may function to avoid damage to the TO-can package and its devices if the assembly is moved.

It will be appreciated that a person skilled in the art can make modifications and improvements in the above described embodiments without departing from the scope of the present invention.

## Claims

1. A method for cooling an electronic or opto-electronic device, the method comprising the steps of:
providing at least one electronic or opto-electronic device (102);
mounting said device on a heat sink assembly (126, 128);
sealing said heat sink assembly (126, 128) within a can having a can body (100) and a can header (104) thermally coupled to the heat sink assembly (126, 128) and closing the can body (100); and
attaching a first portion (141) of a thermal conductor (140) outside said can to at least part of an edge of the header (104) and a second portion (144) of the thermal conductor (140) to a thermal sink (146) outside said can.

2. A method for cooling an electronic or opto-electronic device according to claim 1, wherein said device is a laser device (102).

3. A method for cooling an electronic or opto-electronic device according to either claim 1 or claim 2, wherein said thermal conductor is a clip (140) of thermally conducting material, wherein said first portion (141) includes an annular part (142) for fitting around the edge of the header (104) of the can.

4. A method for cooling an electronic or opto-electronic device according to any one of claims 1 to 3, wherein said second portion (144) is of a size and shape to closely fit to the thermal sink (146).

5. A method for cooling an electronic or opto-electronic device according to any preceding claim, wherein said thermal conductor is a heat pipe (306).

6. A method for cooling an electronic or opto-electronic device according to any one of claims 1 to 4, wherein said thermal conductor is a flexible strap (404) of thermally conducting material which is arranged around at least the edge of the header and attached to the thermal sink (406).

7. A method for cooling an electronic or opto-electronic device according to any preceding claim, wherein said can is a Transistor Outline (TO) can (402).

8. An electronic or opto-electronic device assembly comprising at least one electronic or opto-electronic device (102) mounted on a heatsink assembly (126, 128) within a can having a can body (100) and a can header (104) thermally coupled to the heat sink assembly (126, 128) and closing the can body, and a thermal conductor outside said can and having a first portion (141) attached to at least part of an edge of the can header (104) and a second portion (144) attached to a thermal sink 146 outside said can.

9. An electronic or opto-electronic device assembly according to claim 8, wherein said device is a laser device (102).

10. An electronic or opto-electronic device assembly according to either claim 8 or claim 9, wherein said thermal conductor is a clip (140) of thermally conducting material, wherein said first portion (141) includes an annular part (142) for fitting around the edge of the header (104) of the can.

11. An electronic or opto-electronic device assembly according to claim 10, wherein said clip includes at least one further portion (219) for supporting said clip in position.

12. An electronic or opto-electronic device assembly according to either claim 10 or claim 11, wherein said first portion (141) of said clip (140) is substantially perpendicular to said second portion (144) of said clip.

13. An electronic or opto-electronic device assembly according to any one of claims 8 to 12, wherein said second portion (144) includes a substantially planar part for attaching to the thermal sink

14. An electronic or opto-electronic device assembly according to either claim 8 or claim 9, wherein said thermal conductor is a heat pipe (306).

15. An electronic or opto-electronic device assembly according to either claim 8 or claim 9, wherein said thermal conductor is a flexible strap (404) of thermally conducting material which is arranged around the edge of the header and attached to the thermal sink (406).

16. An electronic or opto-electronic device assembly according to any one of claims 8 to 15, wherein said thermal sink (406) is part of a housing of the assembly.

17. An electronic or opto-electronic device assembly according to claim 16, further comprising an electrically insulating, but thermally conductive material arranged between the thermal conductor and the thermal sink.

18. An electronic or opto-electronic device according to any one of claims 8 to 17 wherein said can is a Transistor Outline (TO) can (402).
